# EUROPÄISCHE PATENTSCHRIFT

(11) **EP 0 707 440 B1**
(45) Veröffentlichungstag und Bekanntmachung des Hinweises auf die Patenterteilung: **12.12.2001**
(21) Anmeldenummer: 95115426.9
(22) Anmeldetag: 29.09.1995
(51) Int. Cl.: H05K 3/42, C25D 5/54

(54) **Verfahren zur direkten galvanischen Durchkontaktierung von zweilagigen Leiterplatten und Multilayern**
Process for making through-hole connections by direct electroplating in double-layered circuit boards and multilayers
Procédé pour établir des connexions à trous débouchants par électroplaquage direct dans des cartes de circuits imprimés à deux couches et multicouches

(30) Priorität: 12.10.1994 DE 4436391
(43) Veröffentlichungstag der Anmeldung: 17.04.1996
(73) Patentinhaber: BAYER AG, 51368 Leverkusen (DE)
(72) Erfinder: Wolf, Gerhard-Dieter, Dr., D-41541 Dormagen (DE); Jonas, Friedrich, Dr., D-52066 Aachen (DE); Schomäcker, Reinhard, Dr., D-51381 Leverkusen (DE)

(56) Entgegenhaltungen:
- EP-A- 0 339 341
- EP-A- 0 553 671

## Beschreibung

Die Erfindung betrifft die Herstellung von durchkontaktierten zweilagigen Leiterplatten und Multilayern unter Verwendung von Polythiophenen für eine leitfähige Ausrüstung der Bohrlöcher zur direkten galvanischen Metallabscheidung. Ein besonderes Merkmal der Erfindung ist der Einsatz von Mikroemulsionen spezieller Thiophene, die in den Bohrlöchern zu den leitfähigen Polythiophenschichten polymerisiert werden.

Verfahren zur Durchkontaktierung von beidseitig kupferkaschierten Leiterplatten, z.B. auf Basis glasfaserverstärkter Epoxidharze sind bekannt (vgl. Herrmann, Handbuch der Leiterplattentechnik, Eugen G. Leuze Verlag, Saulgau). Im allgemeinen werden die Wände der Bohrlöcher in den Leiterplatten nach an sich bekannten Verfahren in chemischen Metallisierungsbädern mit Metallen, vorzugsweise Kupfer beschichtet und so elektrisch leitfähige Verbindungen zwischen der Ober- und Unterseite der Leiterplatten hergestellt. In der Regel werden diese leitfähigen Verbindungen durch galvanische Abscheidung von Kupfer aus Kupferbädern verstärkt.

In der letzten Zeit haben Verfahren an Bedeutung gewonnen, in denen auf den Einsatz chemischer Metallisierungsbäder verzichtet wird und in denen Kupfer direkt galvanisch auf den Bohrlochwandungen von Leiterplatten abgeschieden wird (direct plating). Hierzu ist es erforderlich, die Bohrlochwandungen vor der galvanischen Abscheidung des Kupfers mit einer elektrisch leitfähigen Beschichtung auszurüsten. Diese Beschichtung muß gleichmäßig aufgetragen werden können und außerdem genügend elektrisch leitend sein, um als Basis für eine einwandfreie flächendeckende und lückenlose galvanische Metallisierung (Durchkontaktierung) zu dienen.

In der DE-PS 3 806 884 und der DE-OS 3 927 440 wird beschrieben, Polypyrrol als leitfähige Beschichtung im Bohrloch für die Abscheidung von Kupfer zu verwenden. Die Herstellungsverfahren erfordern folgende Schritte:
1. Herstellung der Bohrungen in den mit Kupfer kaschierten Platten (Basismaterialien)
2. Oxidative Vorbehandlung der Bohrlöcher, z.B. mit alkalischer Kaliumpermanganatlösung
3. Spülen mit Wasser
4. Behandlung mit einer Pyrrollösung
5. Behandlung mit einer wäßrigen Säure zur Auslösung der Polymerisation des Pyrrols zum leitfähigen Polypyrrol im Bohrloch
6. Spülen mit Wasser
7. Galvanische Kupferabscheidung.

Bei der praktischen Durchführung des Verfahrens zeigt es sich, daß das im Schritt 4 auf der Bohrloch-Wand und auf der Leiterplattenoberfläche aufgebrachte Pyrrol nicht nur dem Zweck jener Verfahren entsprechend an der Bohrlochwandung polymerisiert, um die leitfähige Beschichtung zu bilden, wenn es im Schritt 5 in das Säure enthaltende Bad getaucht wird, sondern auch in beträchtlicher Menge abgelöst wird und in einer Art "wilder Polymerisation" im Säurebad selbst polymerisiert. Hierdurch kommt es zur Bildung von Polypyrrolschlamm, der immer wieder aus Bad 5 entfernt werden muß.

Außerdem besteht die Gefahr, daß sich Pyrrol infolge seines niedrigen Dampfdrucks in den Produktionsräumen verteilt und überall dort im Raume polymerisiert, wo sich Säure bzw. Säuredämpfe befinden.

Ebenfalls bekannt (aus DE-OS 4 202 337) ist ein Verfahren zur Herstellung von durchkontaktierten Leiterplatten und Multilayern, in welchem an den Wänden der Bohrlöcher durch Behandeln mit einer Lösung oder Emulsion eines Thiophens der allgemeinen Formel (I) 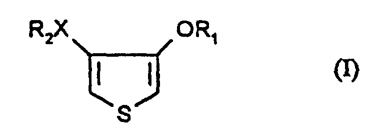 in der
- X: für Sauerstoff oder eine einfache Bindung,
- R₁ und R₂: unabhängig voneinander für Wasserstoff oder eine C₁-C₄-Alkylgruppe stehen oder zusammen einen gegebenenfalls substituierten C₁-C₄-Alkylen-Rest, vorzugsweise einen gegebenenfalls durch Alkylgruppen substituierten Methylen-, einen gegebenenfalls durch C₁-C₁₂-Alkyl- oder Phenylgruppen substituierten Ethylen-1,2-Rest, einen Propylen-1,3-Rest oder einen Cyclohexylen-1,2-Rest bilden,
und gleichzeitige oder anschließende Behandlung mit einer wäßrigen Säure eine leitfähige Schicht aus einem entsprechenden Polythiophen erzeugt und auf diese galvanisch ein Metall abgeschieden wird.

Es hat sich aber herausgestellt, daß nur dann gute, reproduzierbare Ergebnisse erzielt werden, wenn die Konzentration der Polythiophene in der Lösung mindestens 3-5 % beträgt. Diese hohe Konzentration ist in Anbetracht der komplizierten Struktur der einzusetzenden Thiophene aus technischen und wirtschaftlichen Aspekten nicht tragbar.

Verwendet man die Thiophene als Emulsion, dann erhält man schon bei Thiophenkonzentrationen von 1% bis 1,5 % auch im technischen Maßstab befriedigende Ergebnisse. Der Nachteil der Emulsionen besteht aber in ihrer beschränkten Stabilität. Durch Reinigungsprozesse, wie Filtrieren, werden die Emulsionen Scherkräften unterworfen, die die Stabilität der Emulsionen noch weiter herabsetzen.

Gegenstand der Erfindung ist ein Verfahren zur direkten galvanischen Durchkontaktierung von Leiterplatten und Multilayern durch Aufbringen einer leitfähigen Schicht aus einem Polythiophen an den Wänden der Bohrlöcher und galvanische Kupferabscheidung an den Bohrlochwänden, das dadurch gekennzeichnet ist, daß zur Bildung der leitfähigen Polythiophenschicht eine Mikroemulsion eines monomeren Thiophens der Formen (I), 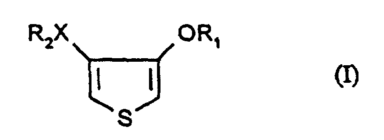 in der
- X: für Sauerstoff oder eine einfache Bindung,
- R₁ und R₂: unabhängig voneinander für Wasserstoff oder eine C₁-C₄-Alkylgruppe stehen oder zusammen einen gegebenenfalls substituierten C₁-C₄-Alkylen-Rest oder einen Cyclohexylen-1,2-Rest bilden,
eingesetzt wird, durch eine anschließende oder gleichzeitige Säurebehandlung, eine leitfähige Schicht aus dem Polythiophen erzeugt wird und schließlich auf dieser leitfähigen Basis ein Metall abgeschieden wird.

Die Erfindung umfaßt dementsprechend ein Verfahren, das folgende Verfahrensschritte enthält:
a) Herstellung von Bohrungen in den mit Kupfer kaschierten Platten und Multilayern
b) Oxidative Vorbehandlung der Bohrlöcher
c) Spülen mit Wasser
d) Behandlung mit einer Mikroemulsion eines Thiophens der Formel (I)
e) Behandlung mit einer Säure
f) Spülen mit Wasser
g) Galvanische Kupferabscheidung.

Die Schritte d) und e) können durch Verwendung einer Mikroemulsion eines Thiophens und einer Säure zu einem Schritt zusammengefaßt werden. Dadurch wird das Verfahren vorteilhafterweise um eine Stufe verkürzt. Die Stabilität der Mikroemulsion ist dann aber nicht mehr ganz so hoch, weshalb es sich letztlich doch empfiehlt, die beiden Stufen
d) Behandlung mit einer Mikroemulsion eines Thiophens der Formel (I)
   und
e) Behandlung mit einer Säure
getrennt durchzuführen.

Die Schritte a), b), c), f) und g) entsprechen dem Stand der Technik und werden in an sich bekannter Weise durchgeführt. Jedoch wird bevorzugt im Schritt b) Kaliumpermanganat in alkalischem Medium eingesetzt. Es hat sich als besonders vorteilhaft erwiesen, eine 4-8 %ige Kaliumpermanganatlösung mit einem pH-Wert zwischen 8 und 10 einzusetzen, wobei akzeptable Ergebnisse auch mit anderen Konzentrationen und pH-Werten der Kaliumpermanganat-Lösungen erzielt werden können.

Bei dem erfindungsgemäßen Schritt d) werden Mikroemulsionen von einem Monomeren der Formel (I) verwendet: 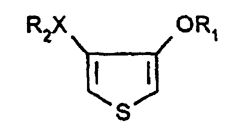 in der
- X: für Sauerstoff oder eine einfache Bindung,
- R₁ und R₂: unabhängig voneinander für Wasserstoff oder eine C₁-C₄-Alkylgruppe stehen oder zusammen einen gegebenenfalls substituierten C₁-C₄-Alkylen-Rest, vorzugsweise einen gegebenenfalls durch Alkylgruppen substituierten Methylen-, einen gegebenenfalls durch C₁-C₁₂-Alkyl- oder Phenylgruppen substituierten Ethylen-1,2-Rest, einen Propylen-1,3-Rest oder einen Cyclohexylen-1,2-Rest bilden.

Bevorzugt stellen in Formel (I) R₁ und R₂ zusammen Alkylen-1,2-Reste dar, die sich von den 1,2-Dibromalkanen ableiten, wie sie beim Bromieren von α-Olefinen, wie Ethen, Propen-1, Hexen-1, Octen-1, Decen-1, Dodecen-1 und Styrol erhältlich sind; oder Cyclohexylen-1,2-, Butylen-2,3-, 2,3-Dimethyl-butylen-2,3- und Pentylen-2,3.

Besonders bevorzugt sind der Methylen-, Ethylen-1,2- und Propylen-1,3-Rest; besonders bevorzugt ist das 3,4-Ethylen-dioxithiophen der Formel (II)

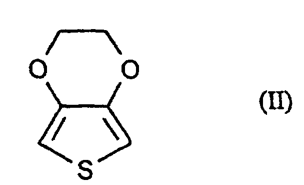

Erfindungsgemäß werden im Schritt d) Mikroemulsionen der ausgewählten Thiophene eingesetzt. Diese sind außerordentlich stabil, garantieren trotz laufender Reinigungsprozesse, beispielsweise Filtrieren über Filterkerzen, sehr hohe Standzeiten und gestalten, das Thiophen in einer technisch und wirtschaftlich vertretbaren niedrigen Konzentration von nur 0,5-1,5 % einzusetzen.

Mikroemulsionen sind an sich bekannt. Sie unterscheiden sich im Wesentlichen von herkömmlichen Emulsionen durch wesentlich kleinere Tröpfchen von 5 bis 100 nm Durchmesser. (Tröpfchendurchmesser der herkömmlichen Emulsionen: 0,5 bis 10 µm). Die Mikroemulsionen sind optisch transparent und thermodynamisch stabil, d. h., es gibt auch nach langen Zeiten keine Trennung der Mikroemulsion in zwei Phasen [Angewandte Chemie 1985, 97, 655].

Die Tröpfchendurchmesser der Mikroemulsion stellt sich als Funktion der Zusammensetzung im Bereich von 5 bis 100 nm ein und ist unabhängig vom Leistungseintrag (Mischungsvorgang), mit dem die Dispergierung erfolgt.

Da die Tröpfchengröße weit unterhalb der Wellenlänge des sichtbaren Lichtes liegt, ist die Mikroemulsion optisch transparent, wie eine Lösung, obwohl Tröpfchen vorliegen, wie in einer Emulsion. Während zur Herstellung einer Emulsion mechanische Energie eingesetzt werden muß, bildet sich eine Mikroemulsion unter leichtem Rühren spontan aus dem Komponenten. Dieser Herstellprozeß der Mikroemulsion ist vergleichbar mit dem Mischen zweier mischbarer Flüssigkeiten.

Voraussetzung für die beschriebene Bildung der Mikroemulsion ist, daß sich die Zusammensetzung und die Temperatur der Mischung innerhalb des Einphasengebietes des Phasendiagrammes des betreffenden Systems befindet. Für jede ternäre Mischung aus Wasser, Thiophen der allgemeinen Formel (I) und einem Tensid ergibt sich ein eigenes Phasendiagramm. In diesen verschiedenen Phasendiagrammen wird das Einphasengebiet jeweils bei anderen Temperaturen und Zusammensetzungen vorgefunden. Der Temperaturbereich des Einphasengebietes wird durch die Hydrophilie des Tensides bestimmt, d.h., mit zunehmender Hydrophilie zu höheren Temperaturen verschoben. Durch die Verwendung von Tensidmischungen kann der Temperaturbereich des Einphasengebietes auf eine gewünschte Temperatur eingestellt werden.

Für die Anwendung wurde das Tensid (bzw. Tensidgemisch) ausgewählt, mit dem das Einphasengebiet sich über die gewünschten Zusammensetzungen und den gewünschten Temperaturbereich erstreckt. An das Einphasengebiet grenzen Zweiphasengebiete an, in denen wiederum normale Emulsionen aus der Mischung aus Wasser, Thiophen der allgemeinen Formel (I) und Tensid entstehen.

Geeignet zur Herstellung der Mikroemulsion sind ionische und nicht-ionische Tenside. Es kann ein einzelnes oder eine Mischung von zwei oder drei Tensiden eingesetzt werden.

Genannt seien im einzelnen: n-Alkyl(C₈-C₁₈)-sulfonate, n-Alkyl(C₈-C₁₈)-benzolsulfonate, n-Alkyl(C₈-C₁₈)-trimethyl-ammoniumsalze, n-Dialkyl(C₈-C₁₈)-dimethylammoniumsalze, n-Alkyl(C₈-C₁₈)-carboxylate, Oligoethylenoxid-mono-n-alkylether (C₆₋₁₈EO₂₋₃₀), n-Alkyl(C₈-C₁₈)-dimethylaminoxid, n-Alkyl(C₈-C₁₈)-dimethylphosphinoxid oder Oligoethylenoxid-mono-n-arylether. Die n-Alkylketten können auch durch teilweise ungesättigte Ketten ersetzt sein.

Bevorzugt für die Durchführung des erfindungsgemäßen Verfahrens ist der Zusatz eines Tensides aus der Gruppe der Oligoethylenoxid-mono-arylether. Besonders bevorzugt sind Tenside der Gruppe PS₂₋₅EO₁₀₋₅₀ der Formel (III), ganz besonders bevorzugt ist PS_{2,8}EO₂₉ der Formel (IV) 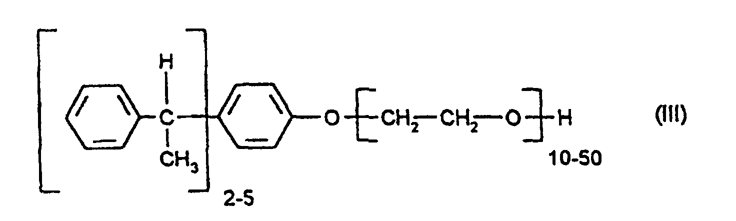 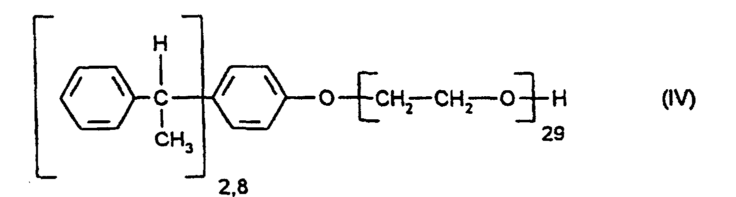 Zur Optimierung der Stabilität der Mikroemulsion können dem Wasser oder dem Konzentrat gegebenenfalls Alkohole (wie z.B. Ethanol, Propanol, Butanol, Hexanol, Heptanol, Oktanol oder Dekanol), Salz (wie z.B. Natriumsulfat, Kaliumsulfat oder ähnliches) oder Säuren (wie z.B. Schwefelsäure) zugesetzt werden.

Besonders bevorzugt werden Mikroemulsionen des Thiophens der Formel (II), dem 3,4-Ethylen-dioxithiophen, im folgenden EDT genannt.

Eine Mikroemulsion des EDT wird bevorzugt hergestellt, indem ein Konzentrat aus EDT und dem Tensid in Wasser gegeben und gut vermischt wird.

Die Zusammensetzung des Konzentrates beträgt
10 bis 90 Gew.-% EDT und
10 bis 90 Gew.-% Tensid,
bevorzugt ist eine Zusammensetzung von
30 bis 70 Gew.-% EDT und
30 bis 70 Gew.-% Tensid,
besonders bevorzugt ist eine Zusammensetzung von
60 Gew.-% EDT und
40 Gew.-% Tensid.

Von diesem Konzentrat werden zur Herstellung der Mikroemulsion 0,1 bis 10 Gew.-% in Wasser gegeben. Bevorzugt ist eine Menge von 0,5 bis 3, besonders bevorzugt 1 - 2,5 Gew.-%.

Besonders bevorzugt werden Zusammensetzungen verwendet, die 0,5 - 1,5 Gew.-% des EDT enthalten.

Selbstverständlich können auch die Komponenten EDT und Tensid in den angegebenen Mengen getrennt dem Wasser zugegeben werden, wobei durch nachträgliches Rühren die Mikroemulsion erzeugt werden kann.

Wie bereits beschrieben, sind derartige Mikroemulsionen besonders bevorzugt, die das EDT in einer Konzentration von 0,5 bis -1,5 Gew.-% enthalten.

Im folgenden sind noch einmal die Vorteile einer erfindungsgemäß einzusetzenden Mikroemulsion zusammengestellt.

Die Mikroemulsion bietet gegenüber den bislang eingesetzten Emulsionen Vorteile, da sie sich unter leichtem Rühren spontan aus Wasser und dem Konzentrat bildet, während für eine normale Emulsion ein definierter, in der Regel hoher Leistungseintrag erforderlich ist. Auch über längere Lagerzeiten ergeben sich keine Änderungen der Zusammensetzung durch Phasentrennungen, wie es bei normalen Emulsionen der Fall ist. Die optische Transparenz erlaubt eine einfache Beurteilung der Stabilität des Systems gegenüber chemischer Alterung durch visuelle Beobachtung.

Die Leiterplatten werden mit der Mikroemulsion bevorzugt bei Temperaturen von 0 bis 90 °C, besonders bevorzugt bei 15 bis 50 °C, behandelt. Die Behandlungsdauer liegt zwischen 1 Sekunde und mehreren Minuten, vorzugsweise 5 Sekunden und 2 Minuten.

Als Säurekomponente e) können bei dem erfindungsgemäßen Verfahren eingesetzt werden:
- Polymere Polysulfonsäuren, beispielsweise Polystyrolpolysulfonsäure oder Polyvinylpolysulfonsäuren oder Copolymere dieser Säuren mit anderen säuregruppenfreien Monomeren. Bevorzugt wird Polystyrolpolysulfonsäure mit einem Sulfonierungsgrad von ca. 90 % in wäßriger Lösung mit einer Konzentration von 0,5 und 5 %, ganz bevorzugt von 1 und 2,5 %.
- Starke anorganische Säuren mit hoher Säurekonzentration, z.B. 20 - 30 %ige Schwefelsäure oder 25 - 50 %ige Phosphorsäure.
- Starke anorganische Säuren in Kombination mit wasserlöslichen Polymeren. Als anorganische Säuren seien genannt: Schwefel-, Phosphor und Salzsäure. Beispiele für wasserlösliche Polymere sind: Polyvinylalkohol, Polyvinylpyrrolidon, Polyacrylsäure, Polystyrolpolysulfonsäure und Copolymerisate mit anderen Monomeren, solange die Copolymerisate wasserlöslich bleiben.
   Den starken anorganischen Säuren, die bevorzugt 10 - 20 %ig eingestellt sind, werden die wasserlöslichen Polymere in Konzentrationen von 0,1 bis 10 %, bevorzugt in Konzentration von 0,5 bis 2,5 %, zugesetzt.
   Beispiele für diese Mischungen sind: 1,5 % Polyvinylalkohol in 20 %iger Schwefelsäure oder 0,5 % Polystyrolpolysulfonsäure in 15 %iger Schwefelsäure oder 1,0 % Polyvinylalkohol in 20 %iger Phosphorsäure.

Die Zusammensetzung der Säurekomponente e) ist für das einwandfreie Gelingen der Durchkontaktierung unter Anwendung der beschriebenen Mikroemulsionen aus EDT von hoher Bedeutung.

Das erfindungsgemäße Verfahren zur Herstellung von durchkontaktierten zweilagigen Leiterplatten und Multilayern unter Verwendung von Polythiophenen als leitfähige Ausrüstung der Bohrlöcher für die direkte galvanische Durchkontaktierung kann unter dem Einsatz aller bisher bekannten Leiterplattenbasismaterialien durchgeführt werden. Bevorzugt werden die folgenden kupferkaschierten Schichtpreßstoffe Phenolharz-Glashartgewebe eingesetzt werden, wobei mit den Epoxidharz-Glashartgeweben besonders gute Ergebnisse erzielt werden.

Das Verfahren kann in für die Durchkontaktierung üblichen Behältern und Geräten ausgeführt werden; die Durchkontaktierung nach der Horizontaltechnik ist bevorzugt, insbesondere, wenn besonders dünne Bohrlöcher oder solche mit einem ungünstigen Längen-/Querschnitt-Verhältnis (wie z.B. bei Multilayern) durchkontaktiert werden sollen.

### Beispiele

### Beispiel 1

Herstellung der Mikroemulsion: In 978 g vollentsalztem Wasser werden 12 g Emulgator PS_{2,8}EO₂₉ gelöst. Dann werden unter starkem Rühren 10 g 3,4-Ethylen-dioxithiophen eingetragen. Es entsteht eine klare, leichte gelbliche Flüssigkeit.

Eine beidseitig kupferkaschierte Leiterplatte aus Epoxidharz-Glashartgewebe wird mit Bohrlöchern versehen. Die Platte wird dann 3 Minuten lang unter Bewegung in einer Lösung aus 6 g Kaliumpermanganat in 100 ml Wasser, die mit Natronlauge auf einen pH-Wert von 9,5 eingestellt worden ist, bei 90 °C gehalten. Anschließend wird die Platte mit Wasser gespült, bis das Wasser farblos abläuft. Die Platte wird dann in die oben beschriebene Mikroemulsion 1 Minute lang bei Raumtemperatur getaucht und ohne zu spülen in eine Lösung von 18 g Polystyrolsulfonsäure in 982 g Wasser überführt. Die Lösung ist auf Raumtemperatur eingestellt; die Verweilzeit beträgt 1 Minute. Danach wird die Platte wieder gut mit Wasser gespült.

Zur Verkupferung der Bohrlöcher wird die Platte an einem Galvanogestell befestigt und bei einer Spannung von ca. 4 A/qdm in einem galvanischen Kupferbad (Cupracid 210 der Fa. Schering) 10 Minuten galvanisiert, um eine lückenlose gut haftende Kupferbeschichtung zu ergeben.

### Beispiel 2

Eine kupferkaschierte Leiterplatte wird, wie in Beispiel 1 beschrieben, mit einer Kaliumpermanganatlösung vorbehandelt und mit Wasser gespült.

Die Platte wird dann in der Mikroemulsion nach Beispiel 1 eine Minute lang getaucht und dann ohne zu spülen in eine Säurelösung überführt, die durch Lösen von 18 g Moviol (Polyvinylalkohol der Fa. Hoechst) in einem Liter 20 %iger Schwefelsäure hergestellt worden ist. Die Verweilzeit betrug 2 Minuten (Raumtemperatur). Nach Spülen in Wasser wird wie in Beispiel 1 beschrieben verkupfert. Diese Behandlung dauerte ca. 8 Minuten bis die Bohrlöcher lückenlos mit Kupfer beschichtet waren (Stromdichte 4 - 5 A/qdm). Die so durchkontaktierte Leiterplatte wurde weiter galvanisch mit Kupfer bis zu eine Dicke von 25 µm verstärkt. Der in der Leiterplattentechnik übliche Thermoschocktest wurde problemlos bestanden.

### Beispiel 3

Es wird wie in Beispiel 1 vorgegangen, wobei eine Mikroemulsion eingesetzt worden ist, die aus 6 g PS_{2,8}EO₂₉, 6 g PS_{2,8}EO₁₆, 12 g 3,4-Ethylen-dioxithiophen und 976 g vollentsalztem Wasser hergestellt worden ist.

Es wurden ebenso gute Ergebnisse, wie in den Beispielen 1 und 2, erhalten. Nach 8 minütiger Metallisierungsdauer unter den beschriebenen Bedingungen waren die Bohrlöcher lückenlos mit einer gut haftenden Kupferschicht belegt und nach Aufbringen einer 25 um dicken Kupferschicht wurde der in der Leiterplattenbranche übliche Thermoschocktest durchgeführt und ohne Probleme bestanden.

### Beispiel 4

Eine beidseitig kupferkaschierte Leiterplatte aus Epoxidharz-Glashartgewebe wird mit 0,8 mm breiten Bohrlöchern versehen. Die Platte wird zum Zwecke ihrer Durchkontaktierung 2 - 3 Minuten lang unter Bewegung in einer Lösung 7 g Kaliumpermanganat in 100 ml Wasser, die einen pH-Wert von 9,2 aufwies, bei 90 °C behandelt. Anschließend wird die Platte mit Wasser gespült, bis das Wasser farblos abläuft. Die Platte wird dann in die in Beispiel 3 beschriebene Mikroemulsion 2 Minuten lang bei Raumtemperatur getaucht und dann ohne Zwischenspülung in eine 30 %ige wäßrige Schwefelsäure überführt. Die Verweilzeit in der Schwefelsäure betrug bei Raumtemperatur eine Minute. Danach wird die Platte mit Wasser gut gespült.

Zur Verkupferung wird die Platte an einem Galvanogestell befestigt und bei einer Spannung von 3 A/qdm in einem galvanischen Kupferbad der Fa. Blasberg Oberflächentechnik (LP 1) 10 Minuten lang galvanisiert, um eine lückenlose, gut haftende Kupferbeschichtung zu ergeben.

### Beispiel 5

Eine kupferkaschierte Leiterplatte wird, wie in Beispiel 4 beschrieben, mit einer Kaliumpermanganatlösung vorbehandelt und mit Wasser gut gespült.

Die Platte wird dann in der Mikroemulsion nach Beispiel 1 eine Minute lang getaucht und dann ohne zu spülen in eine Säurelösung überführt, die durch Lösen von 25 g Polyvinylpyrrolidon in einem Liter 15 %iger Schwefelsäure hergestellt worden ist. Die Verweilzeit betrug 2 Minuten bei Raumtemperatur. Nach Spülen in Wasser wird wie in Beispiel 1 beschrieben verkupfert. Diese Behandlung dauert 6 - 8 Minuten bis die Bohrlöcher lückenlos mit Kupfer beschichtet waren (Stromdichte 3 - 4 A/qdm). Die so durchkontaktierte Leiterplatte wurde weiter galvanisch mit Kupfer bis zu einer Schichtdicke von 25 µm verstärkt. Der in der Leiterplattentechnik übliche Thermoschocktest wurde problemlos bestanden.

## Patentansprüche

1. Verfahren zur direkten galvanischen Durchkontaktierung von Leiterplatten und Multilayern durch Aufbringen einer leitfähigen Schicht aus einem Polythiophen an den Wänden der Bohrlöcher und galvanische Kupferabscheidung an den Bohrlochwänden, **dadurch gekennzeichnet, daß** zur Bildung der leitfähigen Polythiophenschicht eine Mikroemulsion eines monomeren Thiophens der Formel (I), 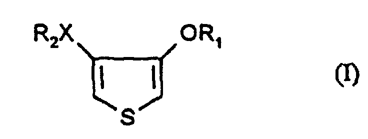 in der
X für Sauerstoff oder eine einfache Bindung,
R₁ und R₂ unabhängig voneinander für Wasserstoff oder eine C₁-C₄-Alkylgruppe stehen oder zusammen einen gegebenenfalls substituierten C₁-C₄-Alkylen-Rest oder einen Cyclohexylen-1,2-Rest bilden,
eingesetzt wird, durch eine anschließende oder gleichzeitige Säurebehandlung, eine leitfähige Schicht aus dem Polythiophen erzeugt wird und schließlich auf dieser leitfähigen Basis ein Metall abgeschieden wird.

2. Verfahren nach Anspruch 1 umfassend folgende Verfahrensschritte:
a) Herstellung von Bohrungen in den mit Kupfer kaschierten Platten und Multilayern
b) Oxidative Vorbehandlung der Bohrlöcher
c) Spülen mit Wasser
d) Behandlung mit einer Mikroemulsion eines Thiophens der Formel (I)
e) Behandlung mit einer Säure
f) Spülen mit Wasser
g) Galvanische Kupferabscheidung.

3. Verfahren nach Anspruch 2, **dadurch gekennzeichnet, daß** die oxidative Vorbehandlung (b) mit Alkalipermanganat zur Ausbildung einer Braunsteinschicht durchgeführt wird.

4. Verfahren nach den Ansprüchen 1 und 2, **dadurch gekennzeichnet, daß** als Thiophen der Formel (I) 3,4-Ethylen-dioxithiophen verwendet wird.

5. Verfahren nach Anspruch 2, **dadurch gekennzeichnet, daß** als Säure (e) eine polymere Polysulfonsäure eingesetzt wird.

6. Verfahren nach Anspruch 2, **dadurch gekennzeichnet, daß** als Säure (e) eine starke wäßrige anorganische Säure in Kombination mit einem Polymeren eingesetzt wird.

7. Verfahren nach Anspruch 2, **dadurch gekennzeichnet, daß** als Säure (e) eine starke anorganische Säure in wäßriger Lösung, aber mindestens in einer Konzentration von 10 % eingesetzt wird.

8. Verfahren nach Anspruch 2, **dadurch gekennzeichnet, daß** als Säure (e) 15 - 20 %ige Schwefelsäure eingesetzt wird.

9. Verfahren nach Anspruch 2, **dadurch gekennzeichnet, daß** als Säure (e) 30 - 50 %ige Phosphorsäure eingesetzt wird.

10. Verfahren nach Anspruch 2, **dadurch gekennzeichnet, daß** die Verfahrensschritte (d) und (e) zu einer Stufe zusammengefaßt werden.

## Claims

1. Process for through-hole plating of circuit boards and multilayers by applying a conductive layer of a polythiophene to the walls of the through-holes and electrodeposition of copper on the walls of the through-holes, **characterized in that** the conductive polythiophene layer is formed by using a microemulsion of a monomeric thiophene of the formula (I) 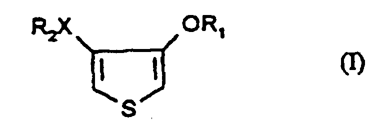 where
X is oxygen or a single bond,
R₁ and R₂ independently represent hydrogen or a C₁-C₄-alkyl group or combine to form an optionally substituted C₁-C₄-alkylene radical or a 1,2-cyclohexylene radical,
generating a conductive layer from the polythiophene by subsequent or simultaneous treatment with acid and finally depositing a metal on this conductive base.

2. Process according to Claim 1, comprising the following process steps:
a) production of through-holes in the copper-clad boards and multilayers
b) oxidative pretreatment of the through-holes
c) rinsing with water
d) treatment with a microemulsion of a thiophene of the formula (I)
e) treatment with an acid
f) rinsing with water
g) electrodeposition of copper.

3. Process according to Claim 2, **characterized in that** the oxidative pretreatment (b) is performed with an alkali metal permanganate to form a layer of manganese dioxide.

4. Process according to Claims 1 and 2, **characterized in that** the thiophene of the formula (I) is 3,4-ethylene dioxythiophene.

5. Process according to Claim 2, **characterized in that** acid (e) is a polymeric polysulphonic acid.

6. Process according to Claim 2, **characterized in that** acid (e) is a strong aqueous inorganic acid combined with a polymer.

7. Process according to Claim 2, **characterized in that** acid (e) is a strong inorganic acid in aqueous solution but with a minimum concentration of 10%.

8. Process according to Claim 2, **characterized in that** acid (e) is 15-20% sulphuric acid.

9. Process according to Claim 2, **characterized in that** acid (e) is 30-50% phosphoric acid.

10. Process according to Claim 2, **characterized in that** process steps (d) and (e) are combined to form a single step.

## Revendications

1. Procédé de métallisation galvanique directe des trous de cartes de circuits imprimés et de multicouches par application d'une couche conductrice constituée par un polythiophène sur les parois des trous débouchants et dépôt galvanique de cuivre sur les parois des trous débouchants, **caractérisé en ce que**, pour la formation de la couche de polythiophène conductrice, on utilise une microémulsion d'un thiophène monomère de formule (I) 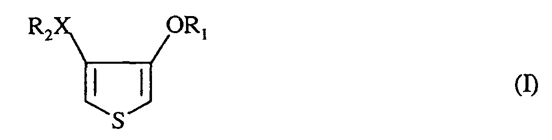 où
X représente l'oxygène ou une simple liaison,
R₁ et R₂ représentent indépendamment l'un de l'autre l'hydrogène ou un groupe alkyle en C₁-C₄ ou représentent ensemble un reste alkylène en C₁-C₄ éventuellement substitué ou un reste cyclohexyl-1,2-ène,
on produit une couche conductrice de polythiophène par un traitement à l'acide subséquent ou simultané et, finalement, on dépose un métal sur cette base conductrice.

2. Procédé selon la revendication 1 comportant les étapes de procédé suivantes :
a) préparation de trous débouchants dans les cartes et multicouches recouvertes de cuivre,
b) prétraitement oxydatif des trous débouchants,
c) lavage à l'eau,
d) traitement avec une microémulsion d'un thiophène de formule (I),
e) traitement avec un acide,
f) lavage à l'eau,
g) dépôt galvanique de cuivre.

3. Procédé selon la revendication 2, **caractérisé en ce que** le prétraitement oxydatif (b) est mis en oeuvre avec un permanganate alcalin pour la formation d'une couche de dioxyde de manganèse.

4. Procédé selon les revendications 1 et 2, **caractérisé en ce que** le 3,4-éthylènedioxythiophène est utilisé comme thiophène de formule (I).

5. Procédé selon la revendication 2, **caractérisé en ce qu'**un acide polysulfonique polymère est utilisé comme acide (e).

6. Procédé selon la revendication 2, **caractérisé en ce qu'**un acide inorganique aqueux fort en combinaison avec un polymère est utilisé comme acide (e).

7. Procédé selon la revendication 2, **caractérisé en ce qu'**un acide inorganique fort en solution aqueuse, mais au moins en une concentration de 10 %, est utilisé comme acide (e).

8. Procédé selon la revendication 2, **caractérisé en ce que** de l'acide sulfurique à 15-20 % est utilisé comme acide (e).

9. Procédé selon la revendication 2, **caractérisé en ce que** de l'acide phosphorique à 30-50 % est utilisé comme acide (e).

10. Procédé selon la revendication 2, **caractérisé en ce que** les étapes de procédé (d) et (e) sont regroupées en une étape.
